# EUROPEAN PATENT APPLICATION

(11) **EP 4 661 299 A1**
(43) Date of publication of application: **10.12.2025**
(21) Application number: 24460021.9
(22) Date of filing: 04.06.2024
(51) Int. Cl.: H04B 1/04, H01J 37/32, H01J 37/34

(54) **HP GENERATOR AND METHOD OF SUPPLYING HP PULSES AND A CONTROL UNIT**

(71) Applicant: TRUMPF Huettinger Sp. Z o. o., 05-220 Zielonka (PL)
(72) Inventor: The designation of the inventor has not yet been filed
(74) Representative: Trumpf Patentabteilung

(57) **Abstract**

HP-generator (10) configured to deliver pulsed high-power (HP) with a high value of voltage and/or high current to a load, in particular to a plasma process, the HP-generator comprising:
a. several switching elements (51, 52) connected in a way to have different potential basis, configured to form high-power-pulses by switching the switching elements on and off, at least some of them at different predetermined times,
b. a control unit (22) configured to drive the switching elements comprising:
i) a combining unit (201) with several combining-unit-input-connections (202, 203, 204) and a combining-unit-output-connection (207), the combining unit configured to combine several input-control-signals (252, 253, 254),
ii) a distributing unit (211) with a distributing-unit-input-connection (217) and several distributing-unit-output-connections (212, 213, 214), the distributing unit configured to distribute the one transceiver-signal (255) at the distributing-unit-input-connection, and
iii) one galvanic isolating transceiver-element (221) for several control signals, each relating to the switching on and off of the switching elements at the predetermined times, the galvanic isolating transceiver-element connected to the combining-unit-output-connection (207) and the distributing-unit-input-connection (217).

## Description

The invention relates to a high-power (HP) -generator configured to deliver pulsed high power with a high value of voltage and/or high current to a load, in particular to a plasma process. The invention also concerns a method of supplying a plasma process with high power pulses.

One example of such a HP-generator is disclosed e.g., in WO2023/161518 A1.

Such a HP-generator consists of several switching elements connected in series configured to form the HP-pulses by switching on and off. Those switching elements should be controlled in a predetermined way. To control the switching elements, a control signal at the input of the switching elements in form of a control voltage and/or control current is preferred. As the switching elements are connected in series at it output, those control signals have different potential as a basis. Therefore, a galvanically isolated control signal for every switching element or for every switching element group, is recommended as disclosed e.g., in WO2023/161518 A1. If the number of such switching elements or switching element groups is high, the costs for such galvanically isolation is high and makes the the HP-generator less reliable due to many parts with failure risk.

The invention relates also to a control unit configured to drive such switching elements in such a HP-generator.

The invention relates also to a combining unit configured to work for, and in particular in, a such HP-generator as a signal combiner.

The invention relates also to a distributing unit configured to work for, and in particular in, a such HP-generator as a signal distributer.

The invention relates also to a method of supplying a plasma process with high power pulses having varying amplitudes provided by such a HP-generator.

The present invention is based on the task of providing a HP-generator, a control unit, a combining unit, a distributing unit, and/or method of operating a plasma process with such a HP-generator with reduced cost and higher reliability.

This task is solved by a HP-generator according to claim 1, distributing unit according to claim 9, a combining unit according to claim 10, a control unit according to claim 13, and/or a method of operating a plasma process according to claim 15. Further embodiments result from the subclaims and/or the description.

The application provides solutions for controlling the switching on and off of multiple switching elements at different predetermined times, distributing control signals to the switching elements, and achieving galvanic isolation for the control signals.

Suggested is a HP-generator configured to deliver pulsed high-power (HP) with a high value of voltage and/or high current to a load, in particular to a plasma process, the HP generator comprising:
a. several switching elements connected in a way to have different potential basis, e.g. connected in series,
   configured to form the HP-pulses by switching the switching elements on and off, at least some of them at different predetermined times,
b. a control unit configured to drive the switching elements, the control unit comprising:
   i. a combining unit with several combining-unit-input-connections and a combining-unit-output-connection,
      the combining unit configured to combine several input-control-signals, each at one of the combining-unit-input-connections to one transceiver-signal at the combining-unit-output-connection,
   ii. a distributing unit with a distributing-unit-input-connection and several distributing-unit-output-connections,
      the distributing unit configured to distribute the one transceiver-signal at the distributing-unit-input-connection to several output-control-signals, each at one of the distributing-unit-output-connection, and
   iii. one galvanic isolating transceiver-element for several control signals, each relating to the switching on and off of the switching elements at the predetermined times,
      the galvanic isolating transceiver-element connected to the combining-unit-output-connection and the distributing-unit-input-connection.

In such a way, the aforementioned task may be accomplished.

In one aspect, each distributing-unit-output-connection is connected with one of the switching elements, in order to control the switching on and off at predetermined times.

In one aspect, the HP generator comprises a driver circuit, connected between at least a part of, in particular each, distributing-unit-output-connection and the switching elements, in order to control the switching on and off at predetermined times.

In one aspect, the driver circuit comprises a drive signal adjuster which may be a separate electronic circuitry. In this way the drive signal itself may stay constant, i.e. without an individual adjustment. In this way the adjustment may be done very fast and wit less interference into the logical circuitry or program, which may be inconveniently slow. In this way the drive signal may also be the same for the switching elements connected in series and the switching adjustment for one or several, in particular all individual switching element(s), may be done by the drive signal adjuster(s). Hence, only one drive signal needs to be generated and there is no need for a control to generate and/or adjust the drive signals for several switch-es. There is no burden on the control for the generation of several drive signals.

In one aspect, the drive signal adjuster is configured to:
- determining a first quantity related to the snubber arrangement of a first switch, in particular a first voltage across a first snubber energy storage component associated with a first switch,
- determining a second quantity related to the snubber arrangement of a second switch, in particular a second voltage across a second snubber energy storage component associated with a second switch,
- comparing the first and second quantities, in particular the first and second voltage,
- based on the comparison adjusting the drive signal of at least the first switching element based on the first quantity.

By adjusting the drive signal even voltage distribution can be achieved. Thus, the individual switching elements can be protected from overvoltage and voltage stress. A fast HV switch unit capable of switching high voltages can thus be realized. Known solutions deal with the driver-dispersion-related voltage unbalance instead of the dispersion itself. According to the development the dispersion is compensated to achieve proper voltage distribution. The compensation works locally at the driver potential. There is no need for extra insulation of additional signals.

Features of such a drive signal adjuster as described here may be better understood with the description of as disclosed in WO 2022/029255 A1.

In one aspect, each combining-unit-input-connection is connected with one of the switching elements, in order to control the switching on and off at predetermined times.

In one aspect, the HP generator comprises several low-power- (LP-) generators, wherein each LP-generator comprises an energy storage component, wherein in use the energy storage component is charged to a predefined value related to the energy storage component, and each LP-generator supplying, in use, at its output an LP-generator-value which corresponds to the value of the energy storage component incorporated in the respective LP-generator.

In one aspect, the HP generator comprises a coupling in which the LP-generators are electrically connected such that a coupling-value at the output of the coupling, which corresponds to the output value of the HP-generator, may be obtained, and which is, in use, at least in some states of the HP-generator higher than the LP-generator-value at the output of one of the LP-generators.

In one aspect, the control unit is configured to select the contribution of LP-generators to the output value of the HP-generator during power delivery of the HP-generator, in order to generate a rise and/or decay of a pulse at the output of the coupling.

In one aspect, the control unit is configured to select the contribution of LP-generators in a galvanically isolated way via the galvanic isolating transceiver-element.

Suggested is a distributing unit with a distributing-unit-input-connection and several distributing-unit-output-connections,
the distributing unit is configured to:
- work for a HP generator as described in this disclosure as a signal distributer,
- distribute one transceiver-signal at the distributing-unit-input-connection to several output-control-signals, each at one of a distributing-unit-output-connection,
- be connected at its distributing-unit-input-connection to the galvanic isolating transceiver-element for several control signals, each relating to the switching on and off of several switching elements at the predetermined times, and
- be connected at its distributing-unit-output-connections to one of the switching elements, respectively, in order to control the switching on and off at predetermined times.

In such a way, the aforementioned task may be accomplished.

In one aspect, the distributing unit comprises a demodulator for at least a part of the, in particular all, demodulated output-control-signals.

In one aspect, the demodulator is adapted to work with the modulator on the combining unit in such a way, that with the demodulated output-control-signals the control unit is able to control the switching of the switching elements on and off.

In one aspect, the distributing unit comprises an optical receiver, in particular with bandwidth of at least 10 GHz.

In one aspect, the distributing unit comprises a splitter.

In one aspect, the splitter may be an optical splitter.

In one aspect, the splitter may be an electrical splitter.

In one aspect, the distributing unit comprises signal amplifiers upstream the demodulators.

Suggested is a combining unit with several combining-unit-input-connections and a combining-unit-output-connection, the combining unit is configured to:
- work for a HP generator as described in this disclosure as a signal combiner,
- combine several input-control-signals, each at one of the the combining-unit-input-connections, to one transceiver-signal at the combining-unit-output-connection,

- be connected at its combining-unit-input-connections to a control signal generation unit, and
- be connected at its combining-unit-output-connection to the galvanic isolating transceiver-element for several control signals, each relating to the switching on and off of several switching elements at the predetermined times.

In such a way, the aforementioned task may be achieved.

In one aspect, the combining unit comprises:
- a control signal generation unit connected to the combining-unit-input-connections,
- the control signal generation unit configured to generate several control signals, each relating to the switching on and off of the switching elements at the predetermined times.

In one aspect, the combining unit comprises a modulator for at least a part of, in particular all, the input-control-signals, configured to get those input-control-signals and output a modulated input-control-signal for those input-control-signals.

In one aspect, the modulator may be an analog modulator configured to perform analog modulation, such as amplitude modulation (AM), frequency modulation (FM), or phase modulation (PM), e.g..

In one aspect, the Modulator may be a digital modulator configured to perform digital modulation, such as quadrature amplitude modulation (QAM), amplitude-shift keying (ASK), frequency-shift keying (FSK), phase-shift keying (PSK), e.g..

Other modulators using other techniques are also conceivable, such as Time-division multiplexing (TDM), frequency-division multiplexing (FDM), Space-division multiple access (SDMA), Polarization-division multiplexing (PDM), Orbital angular momentum multiplexing (OAM), wavelength division multiplexing (WDM), e.g..

In one aspect, the modulator may be a combination of one of the aforementioned modulators configured to perform a combination of modulation, such as Pulse-code modulation (PCM), Delta modulation (DM), Pulse-density modulation (PDM), e.g..

In one aspect, the the modulator may be implemented digital and/or analog.

In one aspect, the the modulator comprises a mixer.

In one aspect, the modulator comprises a filter, in particular a low pass filter, preferred a bandpass-filter, for the input-control-signals.

In one aspect, the combining unit comprises a digital-analog-converter (DAC) and a digital computer unit, configured to:
- modulate the input-control-signals,
- output a digital signal connection and send it to the digital-analog-converter.

In one aspect, the combining unit comprises an optical transmitter, in particular with bandwidth of at least 10 GHz.

In one aspect, the transmitter unit comprises laser diode.

Suggested is a control unit configured to:
- work for a HP generator as described in this disclosure as a control,
- drive the switching elements,
the control unit comprising:
- a combining unit as described in this disclosure, and
- a distributing unit as described in this disclosure.

In such a way, the aforementioned task may be accomplished.

In one aspect, the control unit further comprises one galvanic isolating transceiver-element for several modulated control signals, each relating to the switching on and off of the switching elements at the predetermined times.

In one aspect, the galvanic isolating transceiver-element is connected to the combining-unit-output-connection and the distributing-unit-input-connection.

In one aspect, the the galvanic isolating transceiver-element is built as an optical fiber transmission line.

The use of optical fiber enables galvanic separation between the control system and the controlled one, which in turn leads to ensuring the safety of use of power devices and meeting safety standards.

In one aspect, the galvanic isolating transceiver-element has a bandwidth of at least 100 GHz, in particular at least 1 THz, especially at least 10 THz.

In one aspect, the HP generator may comprise one or more of the afore- or hereinafter-mentioned features of the control unit.

In one aspect, the HP generator may comprise one or more of the afore- or hereinafter-mentioned features of the combining unit.

In one aspect, the HP generator may comprise one or more of the afore- or hereinafter-mentioned features of the distributing unit.

In one aspect, the HP generator may comprise one or more of the afore- or hereinafter-mentioned features of the transceiver-element.

Suggested is a method of supplying a plasma process with high power pulses having varying amplitudes provided by a high-power generator, comprising the steps of
- switching on and off several switching elements connected in a way to have different potential basis, e.g. connected in series, at least some of them at different predetermined times,
- drive the switching elements by a a control unit, wherein the driving the switching elements is done by the following sub-steps:
   - combining several input-control-signals, each at one of a combining-unit-input-connection to one transceiver-signal at a combining-unit-output-connection,
   - distributing one transceiver-signal at a distributing-unit-input-connection to several output-control-signals, each at one of a distributing-unit-output-connection, and
   - transmitting the transceiver-signal over one galvanic isolating transceiver-element for several control signals, each relating to the switching on and off of the switching elements at the predetermined times, and
- forming the high-power pulses with the switching on and off several switching elements.

In such a way, the aforementioned task may be solved.

Additional objects and benefits of the development will be set forth in the description which follows and will be obvious from the description. The objects and benefits of the development may be realized and obtained by means of a method, processes, instrumentalities, and combinations, particularly pointed out in the claims.

In one or more aspects, the method may comprise some or one or more of the afore- or hereinafter-mentioned features of the HP generator, the control unit, combining unit, distributing unit, and transceiver-element.

A detailed description of non-limiting embodiments is presented hereinbelow with reference to the accompanying drawings, in which:
- Fig. 1: is an embodiment of a HP-generator together with a diagram for illustrating signal modulation,
- Fig. 2: is a first embodiment of a of a control unit part with a combining unit,
- Fig. 3: is a second embodiment of a control unit part with a combining unit,
- Fig. 4: is a third embodiment of a control unit part with a combining unit,
- Fig. 5: is a forth embodiment of a control unit part with a distributing unit,
- Fig. 6: is a fifth embodiment of a control unit part with a distributing unit,
- Fig. 7: is a sixth embodiment of control unit part with a transceiver unit,
- Fig. 8: is a seventh embodiment of a control unit part with a transceiver unit,
- Fig. 9: is an eighth embodiment of a control unit part with a transceiver unit,
- Fig. 10: is an embodiment of a plasma process system,
- Fig. 11: is a flowchart showing one example of a method of supplying a plasma process with high power pulses.

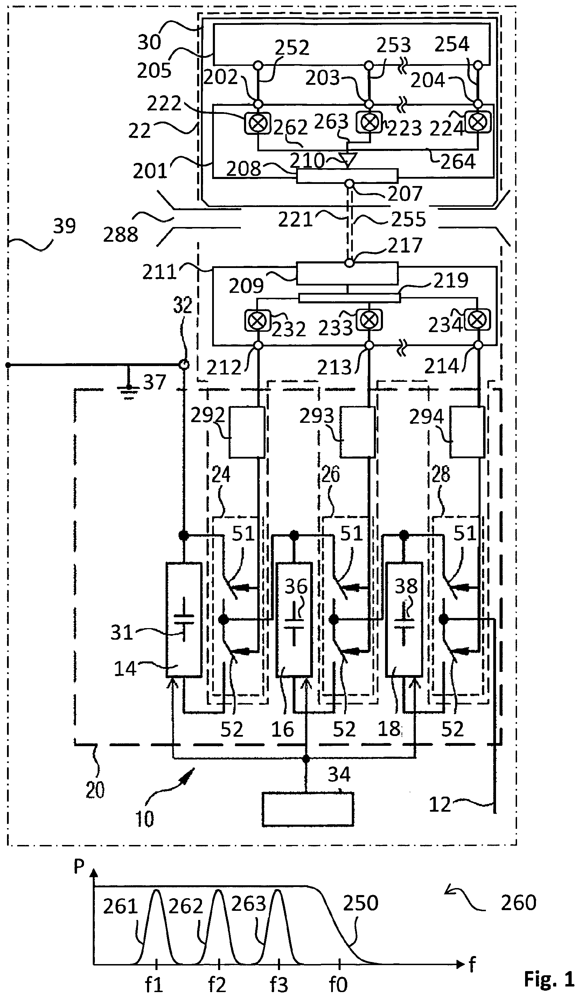

Fig. 1 shows an embodiment of a HP-generator 10 together with a diagram 260 for illustrating a preferred signal modulation. The HP-generator 10 is suitable for producing high power pulses. The HP-generator 10 configured to deliver pulsed high power with a high value of voltage and/or high current to a load, in particular to a plasma process.

In this application, the abbreviation "HP" stands for "high power". "High power" means 10 kW during pulsing or more. High value of voltage means 2 kV during pulsing or more, especially 4 kV or more. High current means 10 A during pulsing or more. In this application, the abbreviation: "LP" stands for "low-power". "Low power" means a power which is at least 4 times lower than the high power of the HP-generator 10.

In one aspect, the load may be a load with a capacitive part. This means that a voltage rise on this load implies a high current capability. The capacitive part may in these cases at least be 100 pF, preferred 200 pF or more, such as around 500 pF. This may be a load in a plasma process as, for example, a plasma treatment application.

In one aspect, the load may be a load with an inductive part. This means that a current rise on this load implies a high voltage capability. The inductive part may in these cases at least be 100 nH, preferred 200 nH or more, such as around 500 nH. This may be a load in an inductive coupled plasma process as, for example, a plasma treatment application with an inductive antenna as electrode.

The load consumes energy and has therefore also a resistive part.

The HP-generator 10 may be configured to influence a voltage and/or movement of charge carriers in a plasma and/or between a plasma potential and a substrate in a plasma process.

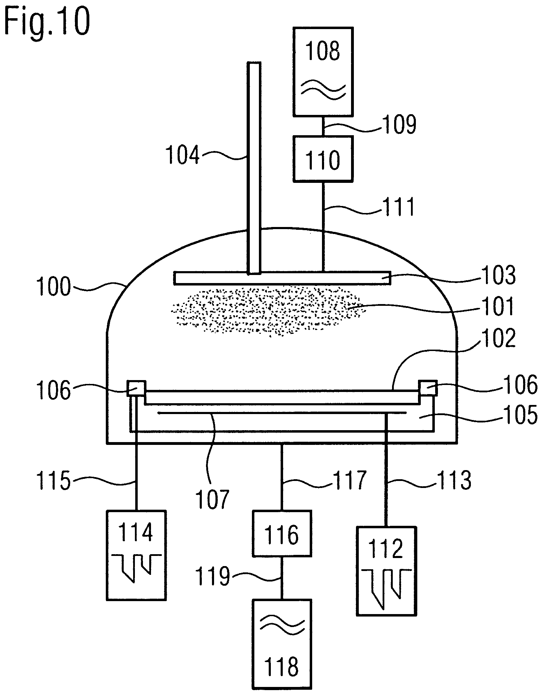

Some plasma treatment applications, such as etching or layer deposition, demand a high voltage (HV), high frequency (HF), rectangular, asymmetrical, pulsed voltage supply. Often the voltage values significantly exceed the voltage handling possibilities of individual semiconductor switching elements, especially when high frequency operation is used. Such an example is shown in Fig. 10 and explained in more detail later.

The HP-generator 10 has a positive output 32 and a negative output 12. The outputs are configured to be connected to the load, in particular the plasma process. The HP-generator 10 comprises several low-power- (LP-) generators 14, 16, 18, wherein each LP-generator 14, 16, 18 comprises an energy storage component 31, 36, 38 in this case embodied as a capacitor. In use the energy storage components 31, 36, 38 are continuously charged to a predefined value related to the energy storage component 31, 36, 38 to keep the energy stored in it constant. In use, each LP-generator 14, 16, 18 supplies at its output an LP-generator-value which corresponds to the value of the energy storage component 31, 36, 38 incorporated in the respective LP-generator 14, 16, 18. The LP-generators 14, 16, 18 are electrically connected in a coupling 20 such that a coupling-value at the output of the coupling 20, which corresponds to the output value of the HP-generator 10, may be obtained, which is higher than the LP-generator-value at the output of one of the LP-generators 14, 16, 18. A control unit 22 is configured to select the contribution of LP-generators 14, 16, 18 to the output value of the HP-generator 10 during power delivery of the HP-generator 10. For clarity reasons, only three LP-generators 14, 16, 18 are shown. Actually, much more LP-generators are used, typically 6 or more, even 10 or more, especially 15 or more, in order to generate stepwise transition of the output which may be as smooth as needed for the load.

The control unit 22 comprises switching units 24, 26, 28 associated with each LP-generator 14, 16, 18. The switching units 24, 26, 28 each comprise switching elements 51, 52. In the embodiment shown the switching elements 51, 52 are connected in series and thus realize a half bridge. The switching units 24, 26, 28 and thus the switching elements 51, 52 are driven by a driver-signal-generator 30 of the control unit 22.

The positive output 32 of HP-generator is connected to ground 37, also called earth potential PE. The LP-generators are connected to a power source 34 comprising transformers, rectifiers and an inverter connected to a grid and itself comprising a full bridge and a buck converter, which will be described in greater detail later.

The components, such as coupling 20, control unit 22, and power source 34 may be enclosed in one cabinet 39. This cabinet 39 may be a metallic cabinet connected to ground 37.

The HP-generator 10 comprises a galvanic isolation 288 between the driver-signal-generator 30 and the switching elements 51, 52.

The control unit 22 comprises switching units 24, 26, 28 associated with each LP-generator 14, 16, 18. The switching units 24, 26, 28 each comprise switching elements 51, 52. In the embodiment shown the switching elements 51, 52 are connected in series and thus realize a half bridge. The switching units 24, 26, 28 and thus the switching elements 51, 52 are driven by a driver-signal-generator 30 of the control unit 22. But the signal from the driver-signal-generator 30 can not be connected directly to the switching units 24, 26, 28, because there is a potential difference between the switching elements 51, 52 as they are connected in series. So, a galvanic isolation 288 between the driver-signal-generator 30 and the switching elements 51, 52 is needed. This galvanic isolation 288 is realized here with the isolating transceiver-element 221.

So, here the control unit 22 is configured to select the contribution of LP-generators 14, 16, 18 in a galvanically isolated way, in particular via magnetically coupling or, preferred, by a fiber optic connection. This may help to switch the LP-generators 14, 16, 18 effectively and fast and with less time delay to form a pulse with sharp edges in voltage, e.g. Several switching elements 51, 52 of one switching unit 24, 26, 28 may be connected by one galvanically isolated connection. Several LP-generators 14, 16, 18 with corresponding switching units 24, 26, 28 may be merged to one group, which may be configured in a way that this group is activated or deactivated only together. Then, for such a group it is possible to use only one galvanically isolated connection. It was known to use a separate galvanic isolation unit for every switch. Groups of transmitters may be controlled simultaneously decreasing the number of control signals required. Reducing the number of galvanically isolated connections may save costs and makes the HP-generator 10 more reliable due to less parts with failure risk.

So, additional effort was made to divide the control unit 22 into two galvanically separated parts:
- firstly a part of a driver-signal-generator 30 which comprises and combining unit 201 and
- secondly a part comprising the switching units 24, 26, 28 and a distributing unit 211.

A single isolating transceiver-element 221 connects both parts. The data from the driver-signal-generator 30 are transferred over this isolating transceiver-element 221 to the distributing unit 211 and the distributing unit 211 distributes the data to the switching units 24, 26, 28.

The combining unit 201 is configured to combine several input-control-signals 252, 253, 254 to a transceiver-signal 255. The transceiver-signal 255 may then be send through a single isolating transceiver-element 221 to the switching element side of the control unit 22.

The driver-signal-generator 30 comprises the combining unit 201 and the control signal generation unit 205.

The control signal generation unit 205 is configured to generate input-control-signals 252, 253, 254.

The combining unit 201 comprises several combining-unit-input-connections 202, 203, 204 and a combining-unit-output-connection 207.

The combining unit 201 is configured to:
a. work for and in the HP generator 10 as a signal combiner,
b. combine the several input-control-signals 252, 253, 254, each at one of the the combining-unit-input-connections 202 -204, to one transceiver-signal 255 at the combining-unit-output-connection 207,
c. be connected at its combining-unit-input-connections 202 -204 to a control signal generation unit 205, and
d. be connected at its combining-unit-output-connection 207 to the galvanic isolating transceiver-element 221 for several control signals, each relating to the switching on and off of several switching elements 51, 52 at the predetermined times.

Inside the control unit 22 is arranged a combining unit 201 with three input connections: a first combining-unit-input-connection 202, a second combining-unit-input-connection 203, and a third combining-unit-input-connection 204. The combining unit 201 comprises several modulators 222, 223, 224, each connected to the combining-unit-input-connections 202 -204 and to a summing unit 210. Each combining-unit-input-connection 202, 203, 204 is linked to a corresponding modulator: a first modulator 222, a second modulator 223, and a third modulator 224. These modulators appear to alter the input-control-signals and pass them to a summing unit 210, where they are combined into a singular transceiver-signal 255. This transceiver-signal 255 is transmitted through an optical transmitter 295 and then passed onto a galvanic isolating transceiver element via the combining-unit-output-connection 207.

The summing unit 210 is embodied as an electronic circuit, capable to combine several electric incoming signals to one outcoming signal with low influence on the incoming signals among themselves. The summing unit 210 may be an amplifier circuit with several input connections and one output connection.

The summing unit 210 is connected at its output to a transmitter unit 208. The transmitter unit 208 comprises the combining-unit-output-connection 207.

Each modulator 222, 223, 224 is configured to modulate the respective input-control-signals 252, 253, 254 at its input connection and output a modulated input-control-signal 262, 263, 264 for those input-control-signals 252, 253, 254, respectively.

A modulator 222, 223, 224 may be an analog modulator configured to perform analog modulation, such as amplitude modulation (AM), frequency modulation (FM), or phase modulation (PM), e.g..

A modulator 222, 223, 224 may be a digital modulator configured to perform digital modulation, such as quadrature amplitude modulation (QAM), amplitude-shift keying (ASK), frequency-shift keying (FSK), phase-shift keying (PSK), e.g..

Other modulators using other techniques are also conceivable, such as time-division multiplexing (TDM), frequency-division multiplexing (FDM), space-division multiple access (SDMA), polarization-division multiplexing (PDM), orbital angular momentum multiplexing (OAM), e.g..

A modulator 222, 223, 224 may also be a combination of one of the aforementioned modulators configured to perform a combination of modulation, such as pulse-code modulation (PCM), delta modulation (DM), pulse-density modulation (PDM), e.g..

A preferred modulator 222, 223, 224 is described in more detail later.

The second part of the control unit 22 comprises the switching units 24, 26, 28 and a distributing unit 211.

The distributing unit 211 comprises a receiver unit 209.

The distributing unit 211 comprises a distributing-unit-input-connection 217 and several distributing-unit-output-connections 212, 213, 214.

The receiver unit 209 comprises a distributing-unit-input-connection 217.

The distributing unit 211 is configured to:
a. work for the HP generator 10 as a signal distributer,
b. distribute one transceiver-signal at the distributing-unit-input-connection 217 to several output-control-signals, each at one of a distributing-unit-output-connection 212 - 214,
c. be connected at its distributing-unit-input-connection 217 to the galvanic isolating transceiver-element 221 for several control signals, each relating to the switching on and off of several switching elements 51, 52 at the predetermined times, and
d. be connected at its distributing-unit-output-connections 212, 213, 214 to one of the switching elements 51, 52, respectively, in order to control the switching on and off at predetermined times.

The distributing unit 211 comprises a demodulator 232, 233, 234 for at least a part of the, in particular all, demodulated output-control-signals 266, 267, 268.

The demodulators 232, 233, 234 are adapted to work with the modulator 222, 223, 224 on the combining unit 201 in such a way, that with the demodulated output-control-signals 266, 267, 268 the control unit 222 is able to control the switching of the switching elements 51, 52 on and off at the at predetermined times.

The distributing unit 211 comprises an optical receiver 281, in particular with bandwidth of at least 10 GHz. In a more detailed view, the receiver unit 209 comprises the optical receiver 281.

The distributing unit 211 comprises a splitter 219.

The splitter 219 may be an optical splitter.

In a preferred embodiment, the splitter 219 may be an electrical splitter.

The splitter is configured to split an incoming signal to several outcoming signals. The outcoming signals are lead to the demodulators 232, 233, 234.

The distributing unit 211 comprises signal amplifiers 276, 277, 278 upstream the demodulators 232, 233, 234. So, the output of the splitter 219 is not overloaded with a low input resistance of a demodulator 232, 233, 234.

The demodulated output-control-signals 266, 267, 268 at the output of the demodulators 232, 233, 234 are lead to the distributing-unit-output-connections 212, 213, 214, respectively.

The control unit 22 comprises on its second part which is towards the switching units 24, 26, 28 driver circuits 292, 293, 294. A distributing-unit-output-connection 212, 213, 214 is connected to the input of a driver circuit 292, 293, 294. So, the demodulated output-control-signals 266, 267, 268 may be amplified by the driver circuits 292, 293, 294, each. The amplified signals may then be lead to the switching units 24, 26, 28 and the control input, such as the gates of the switching elements 51, 52.

Fig. 1 further shows a diagram 260 for illustrating a preferred signal modulation. The frequency f is plotted on the horizontal axis. The power P is plotted on the vertical axis. The transmitter unit 208 may have a transceiver-unit-bandwidth 250 up to the transceiver-unit-bandwidth limit frequency f0.

In the diagram 260 are drafted three modulated input-control-signals 262, 263, 264 modulated with AM or FM with the three carrier frequencies f1, f2, f3, as an example. The carrier frequencies f1, f2, f3 are lower than the transceiver-unit-bandwidth limit frequency f0.

In this way, the input-control-signals 252, 253, 254 may be send over a single isolating transceiver-element 221 and be lead to the switching units 24, 26, 28 as separate driving signals.

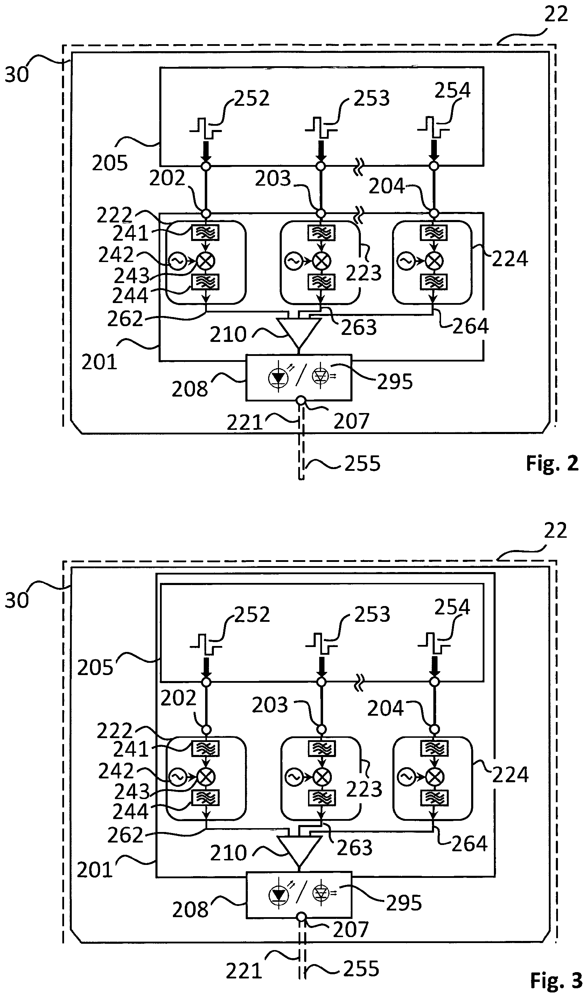

Fig. 2 shows a first embodiment of a part of the control unit 22 with the combining unit 201 in more detail. The transmitter unit 208 comprises an optical transmitter 295. This may be a LED, in particular a Laser-LED.

The schematic illustrates the control unit 22 bounded by a dashed line, which houses several key components for signal processing. The control signal generation unit 205 feeds input-control-signals through combining-unit-input-connections into the combining unit 201. Within the combining unit 201, these signals encounter modulators where they are modulated and pass through mixers and filters associated with a common frequency source 242. The combining unit 201 then outputs a combined transceiver-signal 255 through the combining-unit-output-connection 207. This signal is passed through a galvanic isolating transceiver-element 221 to ensure electrical isolation. An optical transmitter 295 is connected to the combining unit 201, suggesting that the output may be transmitted over an optical link. The transceiver-signal 255 is thus prepared for distribution to various parts of the high-power generator's circuitry for control purposes.

An example of a modulator 222 is shown here in a more detailed view. The modulators 223, 224 are build in a similar way. The modulator 222 may comprise:
- an input filter 241, in particular a low pass filter or a bandpass filter,
- a frequency source 242, in particular with one of the carrier frequencies f1, f2, f3,
- a mixer 243, configured to mix two input signals to an output signal, in particular to multiply both input signals to an output signal which is a representative of a multiplication of both input signals,
- an output filter 244, in particular a low pass filter or a bandpass filter.

The output of the input filter 241 and the output of the frequency source 242 are connected to the input of the mixer 243. The output of the mixer 243 is connected to the input of the output filter 244.

In such a way, the modulators 222, 223, 224 are configured to work out at least some of the following steps:
- filter the incoming signals, in particular the input-control-signals 252, 253, 254,
- mix the incoming signals, in particular the filtered incoming signals, each with a carrier frequency f1, f2, f3,
- filter the mixture of the incoming signals with the carrier frequencies f1, f2, f3,
- output modulated input-control-signals 262, 263, 264.

The control signal generation unit 205 is here part of the driver-signal-generator 30, but external of the combining unit 201.

Fig. 3 shows a second embodiment of a part of the control unit 22 with the combining unit 201.

The difference between the second embodiment of Fig. 3 and the first embodiment of Fig. 2 is that in the second embodiment of Fig. 3 the control signal generation unit 205 is here part of the external of the combining unit 201.

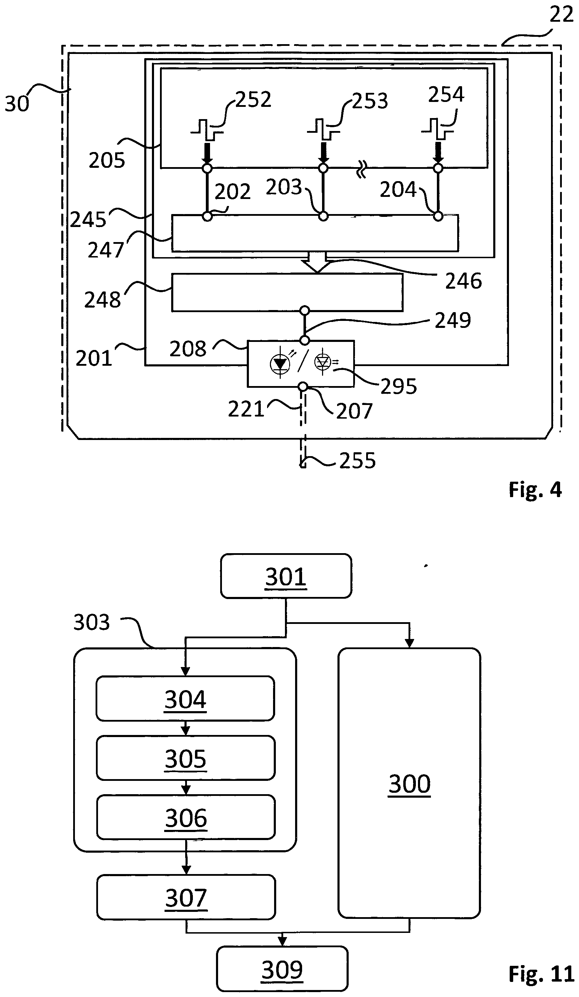

Fig. 4 shows a third embodiment of a part of the control unit 22 with the combining unit 201. In this embodiment the driver-signal-generator 30 comprises a digital variant of the combining unit 201. The control signal generation unit 205 is here again part of the external of the combining unit 201 as in Fig. 3. This is here preferred.

The combining unit 201 comprises a digital computing unit 245, such as a microcontroller, programmable logic device (PLD), or field programmable gate array (FPGA).

The digital computing unit 245 comprises a digital modulator 247 where several examples are described above. A digital signal connection 246 leads an outgoing signal which may be a serial or parallel digital data stream to a digital-analog-converter 248. The digital-analog-converter 248 converts the outgoing signal to a analog signal, which is lead on a analog signal line 249 to the transmitter unit 208. The rest is the same as described above in the description to Fig. 1 to Fig. 3.

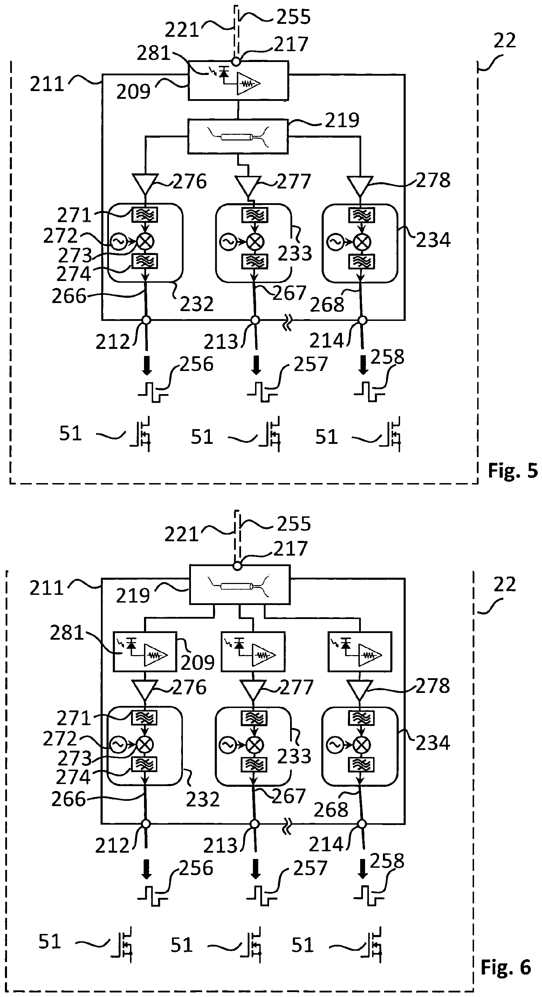

Fig. 5 shows a forth embodiment of a part of the control unit 22 with the distributing unit 211.

The receiver unit 209 comprises a optical receiver 281. The optical receiver 281 converts the optical signals to electric signals. The outcome of the receiver unit 209 is therefore an electric signal which is lead t the splitter 219. The splitter 219 is here en electronic splitter. The outcome of the splitter 219 is lead to signal amplifiers 276, 277, 278. The outcome of the signal amplifiers 276, 277, 278 is lead to the demodulators 232, 234, 235.

An example of a demodulator 232 is shown here in a more detailed view. The demodulators 233, 234 are build in a similar way. The demodulator 232 may comprise:
- an input filter 271, in particular a low pass filter or a bandpass filter,
- a frequency source 272, in particular with one of the carrier frequencies f1, f2, f3,
- a mixer 273, configured to mix two input signals to an output signal, in particular to multiply both input signals to an output signal which is a representative of a multiplication of both input signals,
- an output filter 274, in particular a low pass filter or a bandpass filter.

More carrier frequencies may be used to modulate one signal, depending on the wanted performance of the control signal.

The output of the input filter 271 and the output of the frequency source 272 are connected to the input of the mixer 273. The output of the mixer 273 is connected to the input of the output filter 274.

In such a way, the demodulators 232, 233, 234 are configured to work out at least some of the following steps:
- filter the incoming signals, in particular the splitted parts of the transceiver-signal 255,
- mix the incoming signals, in particular the filtered incoming signals, each with a carrier frequency f1, f2, f3,
- filter the mixture of the incoming signals with the carrier frequencies f1, f2, f3,
- output demodulated output-control-signals 266, 267, 268.

The demodulated output-control-signals 266, 267, 268 are then lead to the distributing-unit-output-connections 212, 213, 214 as the output-control-signals 256, 257, 258. These signals may be used to control the switching elements 51, 52, where here is only one switching elements 51 is shown as an example. Driver circuits 292, 293, 294 as shown in Fig. 1 may also be used here, although not shown here in Fig. 5.

Fig. 6 shows a fifth embodiment of a part of the control unit 22 with the distributing unit 211. Here the transceiver-signal 255 is lead to a splitter 219, which is here an optical splitter. So, the outcome of this splitter 219 are several optical signals which are lead to several optical receivers 281, respectively. The optical receivers 281 convert the optical signals to electric signals. Those electric signals are then lead to the demodulators 232, 233, 234.

The rest is identical to the embodiment of Fig. 5.

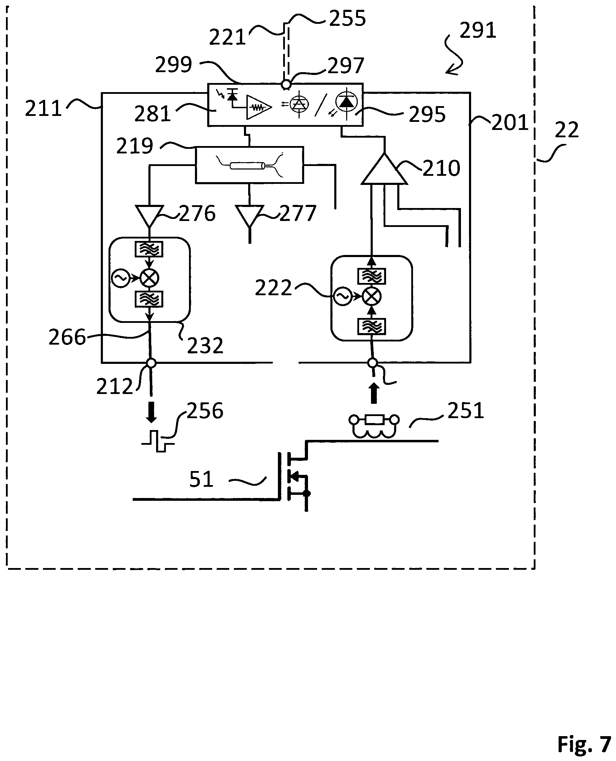

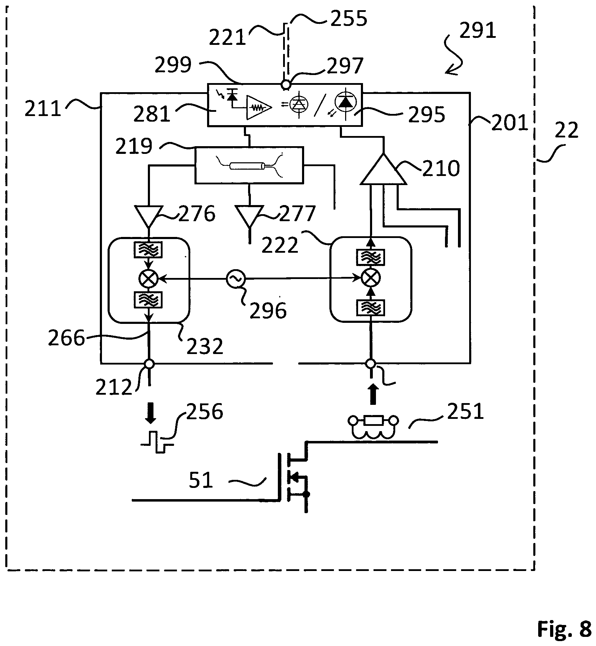

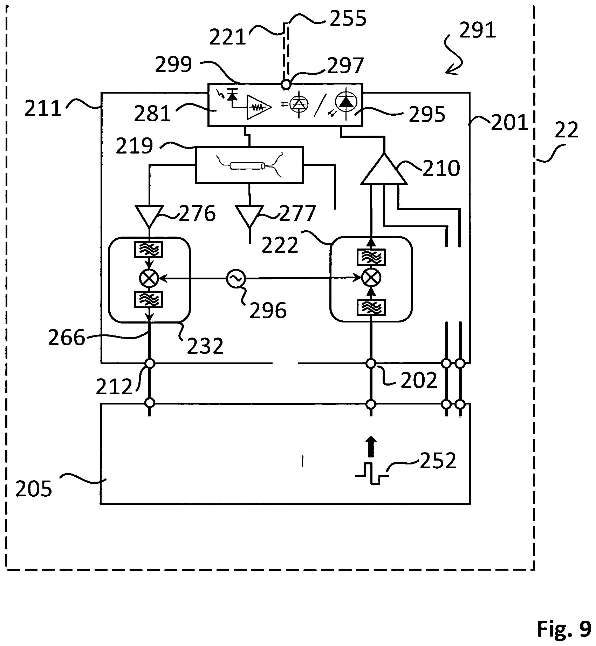

Fig. 7 shows a sixth embodiment of a part of a control unit 22 with a transceiver unit 291. For the explanation of this embodiment, and the corresponding embodiments in Fig. 8 and 9, it is important to understand that the isolating transceiver-element 221 may be used in both directions. So, the receiver unit 209 and the transmitter unit 208 may be combined to a transceiver device 299. The transceiver device 299 may comprise an optical receiver 281 and an optical transmitter 295. The isolating transceiver-element 221 may send signals in both directions wit nearly no interference. The transceiver device 299 comprises a transceiver-connection 297 for connecting the transceiver device 299 with the isolating transceiver-element 221.

With such a configuration on the second part of the control unit towards the switching elements 51, it is possible to bring information from this side in a galvanic isolated way back to the first part of the control unit 22 towards the driver-signal-generator 30. And this is possible on the same isolating transceiver-element 221.

In Fig. 7 is shown a measuring device 251 as an example of a possible signal which may be send back to the driver-signal-generator 30 side of the control unit. The rest of the Fig. 7 may be clear from comparison with the Fig. 1 to 6.

Fig. 8 shows a seventh embodiment of a part of a control unit 22 with a transceiver unit 291. The difference to the embodiment of Fig. 7 is that here one frequency source 296 is used for both, the modulator 222 and the demodulator 232. As the isolating transceiver-element 221 may send signals in both directions with nearly no interference, it is possible to use the same carrier frequency for sending and receiving signals.

Fig. 9 shows an eighth embodiment of a part of a control unit 22 with a transceiver unit 291. Here is shown the first part of the control unit 22 with the driver-signal-generator 30. To work properly with the control unit part shown in Fig. 8, the parts are arranged in a similar way, in particular in the same way. Also here, the transceiver device 299 comprises a transceiver-connection 297 for connecting the transceiver device 299 with the isolating transceiver-element 221.

Fig. 10 shows a plasma processing system with a plasma chamber 100 in which a plasma 101 is established in a plasma space. Such or similar systems are shown and described in US 2020 0118794 A1, US 10,474,184 B2, or US 10,607,813 B2 e.g.. In the plasma chamber an upper electrode 103 may be positioned. A gas inlet and/or outlet, in particular a gas supply pipe 104 may be placed from the outside to the inside of the plasma chamber 100, in particular connected to the electrode 103. A substrate 102, in particular a semiconductor wafer may be placed on a support 105 which comprises a substrate holder inside the plasma chamber 100. In use the substrate 102 may be processed by the plasma 101, e.g., in a process of etching, ashing, or deposition in particular with atomic layered deposition. Etching process may be an extremely high challenge, for instance when the ratio between etched hole diameter and hole length is extremely low, < 1/100, e.g., as it is in deep etching often preferred. An electric conductive electrode 106 may be placed in the plasma chamber 100, in particular nearby the substrate 102, for example around the substrate 102. This electric conductive electrode 106 may be an edge ring which may be also called focus ring. This electric conductive electrode 106 may be connected to a first power supply 114 via a first connection line 115. The first power supply 114 may be a HP-generator 10 as described here. It may be a DC pulsed power supply, where in particular the pulses may be of different length, different amplitude and shaped as described in US 9,287,086 B2 Fig. 11, 14, or US 10,474,184 B2, Fig. 2 e.g.. With the control of the first power supply 114 the electric conductive electrode 106 may be used additionally or alternatively as an ion energy and/or ion acceleration direction control as also described in US 9,287,086 B2 or US 10,474,184 B2. A first radio-frequency (RF) power supply 118 may be electrically connected to the support 105 via a first power feeding rod 119 and a first matching unit 116 and a first connection unit 117. A second radio-frequency (RF) power supply 108 may be electrically connected to the upper electrode 103 via a second power feeding rod 109 and a second matching unit 110 and a second connection unit 111. An electrode 107 may be positioned in or nearby the support 105 and is electrically connected to a second power supply 112 via a second connection line 113. The second power supply 112 may be a HP-generator 10 as described here. It may be a DC pulsed power supply, where in particular the pulses may be of different length, different amplitude and shaped as described in US 9,287,086 B2 Fig. 11, 14, or US 10,474,184 B2, Fig. 2 e.g.. The substrate 102 may be fixed at the support 105 via the electrode 107 which may work as an electrostatic chuck. With the control of the second power supply 112 the electrode 107 may be used additionally or alternatively as an ion energy and/or ion acceleration direction control as described in US 9,287,086 B2 or US 10,474,184 B2.

Some plasma treatment applications, such as etching or layer deposition, demand a high voltage (HV), high frequency (HF), rectangular, asymmetrical, pulsed voltage supply. Often the voltage values significantly exceed the voltage handling possibilities of individual semiconductor switching elements, especially when high frequency operation is required.

Some plasma applications require not only single pulsing, but pulse-to-pulse amplitude variation. Some plasma applications require the source to deliver high peak currents in order to obtain short voltage transition times. Most plasma applications present a load, which contains a capacitive component. Significant power loss is related to the pulse-by-pulse charging and discharging process of this load capacitance. Some plasma applications require pulse shaping as described in US 9,287,086 B2 Fig. 11, 14, or US 10,474,184 B2, Fig. 2, e.g.. Features of a HP-generator 10 as described here may be better understood with the description of WO2023/161518 A1. Features of the HP-generator 10 in WO2023/161518 A1 may also be preferred features of the HP-generator 10 in this application. WO2023/161518 A1 is therefore integrated into this application in its entirety by reference.

Fig. 11 shows a flowchart with one example of a method of supplying a plasma process with high power pulses. It starts in a start 301 and ends at an end 309.

The method of supplying a plasma process with high power pulses having varying amplitudes provided by a high-power generator 10, comprises the following steps:
a. in a switching-step 300, several switching elements 51, 52 connected in a way to have different potential basis, e.g. connected in series, at least some of them at different predetermined times, are switched on and off;
b. in a driving-step 303, the switching elements 51, 52 are switched on and off by a a control unit 22, wherein the driving the switching elements 51, 52 is done by the following sub-steps:
   i. in a combining-step 304, several input-control-signals are combined, each at one of a combining-unit-input-connection 202, 203, 204 to one transceiver-signal at a combining-unit-output-connection 207,
   ii. in a distributing-step 305, one transceiver-signal is distributed at a distributing-unit-input-connection 217 to several output-control-signals, each at one of a distributing-unit-output-connection 212, 213, 214, and
   iii. in a transmitting-step 306, the transceiver-signal is transmitted over one galvanic isolating transceiver-element 221 for several control signals, each relating to the switching on and off of the switching elements 51, 52 at the predetermined times, and
c. in a forming-step 307, the high-power pulses are formed with the switching on and off several switching elements 51, 52.

The configuration of several switching elements 51, 52 with different potential bases may enhance the flexibility and scalability of the high-power generator 10, allowing it to accommodate a wide range of voltage and current requirements for various loads.

By enabling the switching elements 51, 52 to be turned on and off at different predetermined times, the generator may create high-power pulses with precise timing, improving the control over the power delivery to the load.

The inclusion of a control unit 22 with a combining unit 201 and a distributing unit 211 simplifies the control signal management, reducing the complexity of the circuitry and potentially lowering the cost of the overall system.

The HP-generator 10 includes a control unit 22 that may drive the switching elements, enhancing efficient and precise control of the switching on and off at predetermined times.

The combining unit 201 in the control unit 22 may combine multiple input-control signals to one transceiver signal, simplifying the control signal generation process.

The distributing unit 211 in the control unit 22 may distribute the transceiver signal to several output-control signals, allowing for individual control of each switching element.

The galvanic isolating transceiver-element 221 allows the isolation of control signals, enhancing safety and reducing interference between different control signals.

The connection of several, in particular all, distributing-unit-output-connections to a switching element allows that the control signals are delivered with minimal delay, enhancing the response time of the HP-generator 10.

The arrangement facilitates individual control of each switching element 51, 52, allowing for fine-tuning of the power pulses and improving the efficiency of the power delivery to the load.

This configuration may lead to increased reliability of the system, as it may reduce the number of components and connections required for controlling the switching elements, thereby reducing potential points of failure.

The inclusion of a driver circuit between the distributing-unit-output-connections and the switching elements may provide additional signal conditioning, which can protect the switching elements from signal spikes and noise.

The driver circuit can amplify the control signals, allowing that the switching elements receive the appropriate power levels to operate mor effective, which is beneficial for high-power applications.

By serving as an intermediary, the driver circuit can match the electrical characteristics of the control unit to those of the switching elements, improving compatibility and overall system performance.

Connecting each combining-unit-input-connection to a switching element allows for the aggregation of control signals, which can simplify the control strategy and reduce the number of required control lines.

This setup may enhance the synchronization of the switching elements, as the combining unit can process multiple input control signals to create a single, coherent output signal.

The streamlined signal routing can lead to a more compact and organized design, facilitating easier maintenance and potential upgrades to the generator system.

The use of low-power generators 14, 16, 18 with energy storage components 31, 36, 38 allows for the accumulation and controlled release of energy, which can lead to more stable and consistent low-power output values.

Each low-power generator 14, 16, 18 may supply a value corresponding to its incorporated energy storage component enables tailored power delivery to specific parts of the system, enhancing the overall efficiency and adaptability of the generator.

By charging the energy storage components 31, 36, 38 to predefined values, the system can allow that the low-power generators 14, 16, 18 are ready to deliver the power on demand, improving the reliability of the power supply for critical applications.

The inclusion of a coupling 20 for electrically connecting the LP-generators 14, 16, 18 allows for the synthesis of a combined output that can achieve higher power levels than any single LP-generator, thereby enhancing the overall power capacity of the HP-generator 10.

By enabling the output of the coupling 20 to correspond to the output value of the HP-generator 10, the system can maintain a consistent power delivery, which is beneficial for applications requiring stable and reliable energy sources.

The ability to achieve an output at the coupling 20 that is higher than the LP-generator-value in certain states of the HP-generator provides flexibility in managing power distribution and enhancing the generator's performance under varying operational conditions.

The control unit's 22 capability to select the contribution of LP-generators during power delivery helps for precise control over the rise and decay of pulses, which is beneficial for applications that demand specific pulse shaping and timing.

This selective control of LP-generator contributions may enhance the efficiency of the HP-generator by increasing the power output according to the immediate requirements of the load, thus reducing energy wastage.

The dynamic adjustment of LP-generator contributions can lead to improved system responsiveness and adaptability, enabling the generator to cater to a wide range of power demands with minimal manual intervention.

The galvanically isolated selection of LP-generator contributions allows that the control unit 22 can operate with lower risk of electrical interference, which enhances the safety and reliability of the system.

Galvanic isolation 288 in the control process reduces potential damage to sensitive electronic components, thereby extending the lifespan of the generator and decreasing maintenance costs.

The use of a galvanic isolating transceiver-element 221 in controlling the LP-generators allows for the integration of the generator into systems with different ground potentials, increasing its compatibility and application scope.

The distributing unit's 211 ability to work as a signal distributor for a HP generator 10 facilitates the coordination of multiple control signals, streamlining the power management process.

By distributing a single transceiver-signal 255 to several output-control-signals, the distributing unit 211 may simplify the control architecture, reducing the complexity and potential points of failure within the system.

The connection of the distributing unit 211 to the galvanic isolating transceiver-element 221 for control signals related to switching elements allows precise timing and synchronization, which is good for maintaining the efficiency and performance of the generator.

The combining unit's 201 function as a signal combiner allows for the aggregation of multiple control signals into a single transceiver-signal 255, which may simplify the signal processing and reduces the risk of signal collision.

By being connected to a control signal generation unit 205, the combining unit 201 allows that the input-control-signals are accurately reflected in the combined transceiver-signal 255, which may lead to more effective control of the switching elements.

The connection of the combining unit 201 to the galvanic isolating transceiver-element 221 facilitates the safe transmission of control signals for the operation of switching elements, which may be beneficial for maintaining the integrity and reliability of the power generation process.

The inclusion of a digital-analog-converter 248 and a digital computer unit allows for precise modulation of input-control-signals, enhancing the accuracy and reliability of the control signals used to operate the system.

By outputting a digital signal connection 246 and sending it to the digital-analog-converter 248, the system allows a seamless transition between digital and analog domains, improving signal integrity and reducing potential conversion errors.

The presence of an optical transmitter 295 with a bandwidth of at least 10 GHz enables high-speed data transmission, which may be beneficial for applications requiring low delay differences between components.

The use of an optical transmitter 295 reduces electromagnetic interference, allowing that the transmitted signals maintain high fidelity even in environments with significant electronic noise.

The control unit's 22 ability to work with a high-power generator as specified above enhances system compatibility and allows for a standardized approach to controlling various HP generators.

The inclusion of a combining unit 201 and a distributing unit 211 within the control unit 22 facilitates efficient signal processing, enabling simultaneous control of multiple switching elements and improving the overall response time of the system.

By allowing for the transmission of several modulated control signals by the galvanic isolating transceiver-element 221 and related to the precise timing of switching elements, the system can achieve synchronized operation of components at different electrical potentials, enhancing safety and reliability.

The step-by-step driving of the switching elements 51, 52 through combining, distributing, and transmitting control signals via a galvanic isolating transceiver-element 221 facilitates the high-power pulses formed with high accuracy, decreasing the risk of power loss or component damage due to timing discrepancies.

## Claims

1. High-power (HP)-generator (10) configured to deliver pulsed high-power with a high value of voltage and/or high current to a load, in particular to a plasma process, the high-power-generator (10) comprising:
a. several switching elements (51, 52) connected in a way to have different potential basis, e.g. connected in series,
configured to form high-power-pulses by switching the switching elements (51, 52) on and off, at least some of them at different predetermined times,
b. a control unit (22) configured to drive the switching elements (51, 52), the control unit (22) comprising:
i. a combining unit (201) with several combining-unit-input-connections (202, 203, 204) and a combining-unit-output-connection (207),
the combining unit (201) configured to combine several input-control-signals (252, 253, 254), each at one of the combining-unit-input-connections (202, 203, 204) to one transceiver-signal (255) at the combining-unit-output-connection (207),
ii. a distributing unit (211) with a distributing-unit-input-connection (217) and several distributing-unit-output-connections (212, 213, 214),
the distributing unit (211) configured to distribute the one transceiver-signal (255) at the distributing-unit-input-connection (217) to several output-control-signals (256, 257, 258), each at one of the distributing-unit-output-connection (212, 213, 214), and
iii. one galvanic isolating transceiver-element (221) for several control signals, each relating to the switching on and off of the switching elements (51, 52) at the predetermined times,
the galvanic isolating transceiver-element (221) connected to the combining-unit-output-connection (207) and the distributing-unit-input-connection (217).

2. HP generator (10) according to claim 1, wherein each distributing-unit-output-connection (212-214) is connected with one of the switching elements (51, 52), in order to control the switching on and off at predetermined times.

3. HP generator (10) according to one of the preceding claims, wherein the HP generator (10) comprises a driver circuit (292, 293, 294) connected between at least a part of, in particular each, distributing-unit-output-connection (212, 213, 214) and the switching elements (51, 52), in order to control the switching on and off at predetermined times.

4. HP generator (10) according to one of the preceding claims, wherein each combining-unit-input-connection (202-204) is connected with one of the switching elements (51, 52), in order to control the switching on and off at predetermined times.

5. HP generator (10) according to one of the preceding claims, wherein the HP generator (10) comprises several low-power (LP)-generators (14, 16, 18),
a. each LP-generator (14, 16, 18) comprising an energy storage component (31, 36, 39), wherein in use the energy storage component (31, 36, 38) is charged to a predefined value related to the energy storage component,
b. each LP-generator (14, 16, 18) supplying, in use, at its output an LP-generator-value which corresponds to the value of the energy storage component (31, 36, 38) incorporated in the respective LP-generator (14, 16, 18).

6. HP generator (10) according to one of the preceding claims, wherein the HP generator (10) comprises a coupling (20) in which the LP-generators (14, 16, 18) are electrically connected such that a coupling-value at the output of the coupling (20), which corresponds to an output value of the HP-generator (10), may be obtained, and which is, in use, at least in some states of the HP-generator (10) higher than the LP-generator-value at the output of one of the LP-generators (14, 16, 18).

7. HP generator (10) according to one of the preceding claims, wherein the control unit (22) is configured to select the contribution of LP-generators (14, 16, 18) to an output value of the HP-generator (10) during power delivery of the HP-generator (10), in order to generate a rise and/or decay of a pulse at the output of the coupling (20).

8. HP generator (10) according to one of the preceding claims, wherein the control unit (22) is configured to select the contribution of LP-generators (14, 16, 18) in a galvanically isolated way via the galvanic isolating transceiver-element (221).

9. Distributing unit (211), with a distributing-unit-input-connection (217) and several distributing-unit-output-connections (212, 213, 214),
the distributing unit (211) is configured to:
a. work for a HP generator (10) according to one of the preceding claims as a signal distributer,
b. distribute one transceiver-signal at the distributing-unit-input-connection (217) to several output-control-signals, each at one of a distributing-unit-output-connection (212, 213, 214),
c. be connected at its distributing-unit-input-connection (217) to the galvanic isolating transceiver-element (221) for several control signals, each relating to the switching on and off of several switching elements (51, 52) at the predetermined times, and
d. be connected at its distributing-unit-output-connections (212, 213, 214) to one of the switching elements (51, 52), respectively, in order to control the switching on and off at predetermined times.

10. Combining unit (201) with several combining-unit-input-connections (202, 203, 204) and a combining-unit-output-connection (207),
the combining unit (201) is configured to:
a. work for a HP generator (10) according to one of the preceding claims as a signal combiner,
b. combine several input-control-signals (252, 253, 254), each at one of the the combining-unit-input-connections (202 -204), to one transceiver-signal (255) at the combining-unit-output-connection (207),
c. be connected at its combining-unit-input-connections (202 -204) to a control signal generation unit (205), and
d. be connected at its combining-unit-output-connection (207) to the galvanic isolating transceiver-element (221) for several control signals, each relating to the switching on and off of several switching elements (51, 52) at the predetermined times.

11. Combining unit (201) according to claim 10, comprising a digital-analog-converter (248) and a digital computer unit (247), configured to:
a. modulate the input-control-signals (252, 253, 254),
b. output a digital signal connection (246) and send it to the digital-analog-converter (248).

12. Combining unit (201) according to one of the preceding claims 10 - 11, comprising an optical transmitter (295), in particular with bandwidth of at least 10 GHz.

13. Control unit (22) configured to
a. work for a HP generator (10) according to one of the preceding claims 1 - 8 as a control,
b. drive the switching elements (51, 52),
the control unit (22) comprising:
- a combining unit (201) according to one of the preceding claims 10 - 12, and
- a distributing unit (211) according to claim 9.

14. Control unit (22) according to claim 13, further comprising one galvanic isolating transceiver-element (221) for several modulated control signals (262, 263, 264, 266, 267, 268), each relating to the switching on and off of the switching elements (51, 52) at the predetermined times,
the galvanic isolating transceiver-element (221) connected to the combining-unit-output-connection (207) and the distributing-unit-input-connection (217).

15. Method of supplying a plasma process with high power pulses having varying amplitudes provided by a high-power generator (10), comprising the steps of:
a. switching on and off several switching elements (51, 52) connected in a way to have different potential basis, e.g. connected in series, at least some of them at different predetermined times,
b. drive the switching elements (51, 52) by a a control unit (22), wherein the driving the switching elements (51, 52) is done by the following sub-steps:
i. combining several input-control-signals, each at one of a combining-unit-input-connection (202, 203, 204) to one transceiver-signal at a combining-unit-output-connection (207),
ii. distributing one transceiver-signal at a distributing-unit-input-connection (217) to several output-control-signals, each at one of a distributing-unit-output-connection (212, 213, 214), and
iii. transmitting the transceiver-signal over one galvanic isolating transceiver-element (221) for several control signals, each relating to the switching on and off of the switching elements (51, 52) at the predetermined times, and
c. forming the high-power pulses with the switching on and off several switching elements (51, 52).
